# EUROPÄISCHE PATENTSCHRIFT

(11) **EP 2 558 614 B1**
(45) Veröffentlichungstag und Bekanntmachung des Hinweises auf die Patenterteilung: **20.11.2013**
(21) Anmeldenummer: 11826120.5
(22) Anmeldetag: 29.12.2011
(51) Int. Cl.: C23C 16/36, B21C 25/02

(54) **VERFAHREN ZUM ERZEUGEN EINER BESCHICHTUNG AUF EINEM STRANGPRESSWERKZEUG**
METHOD FOR PRODUCING A COATING ON AN EXTRUSION DIE
PROCÉDÉ DESTINÉ À CRÉER UN REVÊTEMENT SUR UN OUTIL D'EXTRUSION

(30) Priorität: 22.06.2011 DE 102011051276
(43) Veröffentlichungstag der Anmeldung: 20.02.2013
(60) Teilanmeldung: 13187049.5
(73) Patentinhaber: WEFA Singen GmbH, 78224 Singen (DE)
(72) Erfinder: MAIER, Joachim, 78224 Singen (DE); MAIER, Oliver, 78315 Radolfzell (DE); BÜRGIN, Werner, CH-4450 Sissach (CH); HOLZSCHUH, Helga, 72537 Mehrstetten (DE)
(74) Vertreter: Behrmann, Niels
(86) Internationale Anmeldenummer: PCT/EP2011/074224
(87) Internationale Veröffentlichungsnummer: WO 2012/175147

(56) Entgegenhaltungen:
- EP-A1- 0 769 570
- DE-A1- 3 221 388
- DE-A1- 3 431 892
- US-A1- 2006 032 334
- US-A1- 2011 139 958
- US-B1- 6 176 153

## Beschreibung

Die vorliegende Erfindung betrifft das Gebiet der Strangpresstechnik, dort ein Verfahren zum Erzeugen einer Beschichtung auf einem Strangpresswerkzeug. Geeignetes Strangpressmetall, typischerweise eine Aluminiumlegierung, wird unter hohem Druck durch eine von einem Strangpresswerkzeug zumindest abschnittsweise begrenzte Öffnung gepresst, besitzt während dieses Pressvorgangs und beim Durchtritt durch das Werkzeug eine duktile, zähflüssige Konsistenz und kann so, je nach Ausgestaltung des Strangpresswerkzeugs, in eine geeignete, auch komplexe Profilkonfiguration verbracht werden.

Nicht zuletzt aufgrund der besonderen Umstände der Strangpresstechnologie, nämlich ein kontinuierliches, vergleichsweise langsames Entlangfließen des duktilen Strangpressmetalls an der (stationären) Werkzeugoberfläche unter hohem Druck und bei hoher Temperatur, sind besondere Erfordernisse an die Ausgestaltung des Werkzeugs bzw. an das für das Werkzeug eingesetztes Material (Substrat) zu stellen. Einerseits ist eine besonders verschleißfeste Oberfläche, insbesondere an den Kontaktbereichen mit dem Strangpressmetall, sicherzustellen, was typischerweise über eine geeignete, die Oberflächenhärte erhöhende Beschichtung bzw. Oberflächenbehandlung (Nitrieren etc.) realisiert wird. Andererseits erfordern die besonderen Bedingungen des Strangpressens sowie die besonderen Geometrien (lange Zungen, dünne Stege) der Strangpressprofile eine gewisse Duktilität des Werkzeugs, so dass sich etwa der ansonsten ja denkbare Einsatz von besonders harten (aber spröden) Werkstoffen, wie etwa Hartmetallen oder Schnellstähle, verbieten. Ferner stellen die hohen Einsatztemperaturen zwischen 500°C - 640°C erhöhte Anforderungen an die Anlassbeständigkeit und Dauerwarmfestigkeit der eingesetzten Stähle, was den möglichen Einsatz von Kaltarbeitsstählen als Werkstoff für ein solches Strangpresswerkzeug ausschließt.

Aus dem Stand der Technik ist es zur Herstellung von beschichteten Werkzeugen für die Strangpresstechnologie prinzipiell bekannt, eine die Verschleißfestigkeit erhöhende Beschichtung mittels sogenannter Hochtemperatur(HT-)-CVD=Verfahren aufzubringen. So offenbart etwa die EP 1 011 885 B1 der Anmelderin ein Verfahren zur Beschichtung eines Strangpresswerkzeugs mittels Hochtemperatur-CVD, bei welchem eine metallische Phase (in ansonsten bekannter Weise) durch das CVD-Verfahren auf die Substratoberfläche, nämlich das geeignet vorbereitete und ausgeformte Werkzeug, gebracht wird. Bevorzugte Verarbeitungstemperaturen dieses Hochtemperatur-Verfahrens liegen oberhalb von 950°C; bei diesen Temperaturen ist eine optimale Reaktivität der eingesetzten Gase für eine Gasabscheidung vorhanden. Bei geringeren Temperaturen können die Gase mit HT-CVD dagegen nicht prozesssicher und mit guten Schichteigenschaften abgeschieden werden.

Patent Dokument US 6176153 offenbart ein Verfahren zur Abscheidung von TiN auf Strangpresswerkzeugen aus warmfesten Stahl für das Strangpressen von Aluminium.

Insbesondere sorgt auch diese hohe Temperatur im Stand der Technik dafür, dass die Warmarbeitsstähle bei den hohen CVD-Temperaturen stark überhitzen und überzeiten. Dies führt zu Versprödung, Grobkornbildung, Korngrenzenbelegung und einer damit verbundenen, deutlich reduzierten Zähigkeit (von typischerweise 400 J bis hinunter zu 150 - 300 J gemäß Schlagbiegeversuch nach DIN SEP 1314). Konsequenz ist, dass die Strangpresswerkzeuge nach wie vor relativ schnell verschleißen, so dass hier Optimierungsbedarf besteht.

Zwar offenbart die o.a. Schrift mit in einem nach unten erweiterten Temperaturbereich bis zu 700°C auch formal einen gegenüber dem Hochtemperaturbereich bis in den so genannten Mitteltemperaturbereich hinein abgesenkten Temperaturrahmen, jedoch ist mit dem in diesem als gattungsbildend herangezogenen Stand der Technik beschriebenen Verfahren keine hinreichend zähe und harte Schicht, in Verbindung mit einem die Zähigkeitseigenschaften und damit die Verschleißfestigkeit begünstigenden Substratgefüge erreichbar. Insbesondere würde nämlich eine derartige niedrige Temperatur ohne weitere Maßnahmen verhindern, dass ausreichend Kohlenstoff als Element und Bestandteil der härtenden Beschichtung abgeschieden wird, so dass die Verschleiß- und Härteeigenschaften einer hypothetisch bei Temperaturen unterhalb von 1000°C abgeschiedenen CVD-Beschichtung, wie sich erfindungsgemäß gezeigt hat, nicht ausreichen, so dass der einschlägige Fachmann eine derartige Variante ohnehin in der Beschichtungspraxis und für einen Einsatz als Strangpresswerkzeug nicht erwägen würde.

Die Aufgabe wird durch das Verfahren zum Erzeugen einer ein- oder mehrschichtigen Beschichtung auf einem Strangpresswerkzeug als Substratkörper mit den Merkmalen des Patentanspruchs 1 gelöst, vorteilhafte Weiterbildungen der Erfindung sind in den Unteransprüchen beschrieben.

In erfindungsgemäß vorteilhafter Weise hat sich zunächst herausgestellt, dass sich insbesondere die Konzentration von Kohlenstoff, weiter vorteilhaft die relative Konzentration von Kohlenstoff im Vergleich zum Element Stickstoff, als kritisch für die beabsichtigten verbesserten Härteeigenschaften erweist. Diese Härte führt insbesondere auch zu einer besseren Stützwirkung bei der Verwendung einer weiterbildungsgemäß möglichen zusätzlichen Deckschicht.

Dabei hat sich weiterhin günstig im Rahmen der Erfindung herausgestellt, dass zwar durch die im Stand der Technik offenbarte Technologie die notwendige hohe Kohlenstoffkonzentration (gerade bei niedrigen Temperaturen im sogenannten Mitteltemperaturbereich, nämlich unterhalb von 1000°C) nicht realisierbar ist, durch das erfindungsgemäße Hinzuführen geeigneter, kohlenstoffhaltiger Gasströme als (weiteres) Reaktionsgas hier jedoch diese Konzentration respektive das C/N-Verhältnis signifikant gesteigert werden kann.

Dabei stellt sich weiterhin als vorteilhaft im Rahmen der Erfindung heraus, dass durch das Beschränken der Prozesstemperatur des erfindungsgemäßen CVD-Beschichtungsprozesses im Rahmen des Verfahrens zum Erzeugen einer ein- oder mehrschichtigen Beschichtung keine nachteilige Beeinflussung der Oberflächeneigenschaften des Werkzeugs entsteht (wie es etwa bei dem bekannten Hochtemperatur-Verfahren der Fall ist), also etwa keine (aufgrund hoher Betriebstemperaturen resultierende Verschlechterung des Substratgefüges bei, gegenüber typischerweise spröden Hochtemperatur-CVD-Oberflächen, eine deutlich höherer Zähigkeit und Elastizität, welche wiederum, in der eingangs diskutierten Weise, die Nutzung im Rahmen von Strangpressvorgängen begünstigt.

Weitere vorteilhafte Wirkung im Rahmen der vorliegenden Erfindung ist, dass durch das Durchführen des CVD-Beschichtungsprozesses bei der erfindungsgemäß beanspruchten Mitteltemperatur, insbesondere im Bereich zwischen 700 °C und 950°C, weiter bevorzugt im Bereich zwischen 850°C und 900°C, eine vorteilhafte kolumnare und/oder stengelige Struktur entsteht, welche eine Vielzahl voneinander benachbarten und typischerweise zueinander parallel und senkrecht zur Substratoberfläche ausgerichtete Wachstumsrichtung (Kornorientierung) aufweist. Dabei ist als "kolumnar" bzw. "stengelig" eine solche Schichtstruktur zu verstehen, bei welcher die Kornorientierung parallel zur Wachstumsrichtung aufwächst, in der Art voneinander benachbarten, typischerweise in etwa senkrecht zur Substrat- und/oder Beschichtungsoberfläche verlaufenden Säulenstrukturen, eine Anordnung aus langgestreckten Strukturabschnitten erzeugt, welche jeweils von benachbarten Säulen abgegrenzt sind und potenziell das Einlagern von Elementen in die Zwischenräume zwischen benachbarten Säulen ermöglichen; der Begriff "Säule" meint dabei nicht notwendiger Weise zylindrische Anordnungen, vielmehr steht das Attribut der gerichteten Struktur/Textur (z.B. in Richtung der [100] Struktur) im Vordergrund, etwa bei gängigen analytischen bzw. Visualisierungs-Verfahren einer solchen Schicht klar erkennbar.

Die stengelige Struktur wiederum erhöht die Verschleißeigenschaften, reduziert die Oberflächenrauheit und verbessert Diffusionsfähigkeit der Dotierungselemente sowie die thermische Leitfähigkeit. Diese Eigenschaften wirken sich vorteilhaft für die Anwendung des Strangpressens aus. In die Zwischenräume einer solchen, der nachteiligen Sprödigkeit des Materials entgegenwirkenden Gefügestruktur kann dann geeignetes Dotierungsmaterial (typischerweise Sauerstoff oder Bor, Cr, Zr) eindiffundieren und in erfindungsgemäß vorteilhafter Weise besonders günstige, einem nachteiligen Kleben/Anhaften oder Abrasion entgegenwirkende Oberflächeneigenschaften bewirken.

Eine wiederum vorteilhafte Folge dieser erfinderischen Maßnahme ist die Möglichkeit, eine Verarbeitungstemperatur des Strangpressmetalls beim Pressen (respektive dem Durchtritt durch das Strangpresswerkzeug) gegenüber konventionellen Prozessen absenken zu können, da, wie dargelegt, durch das verminderte Kleben eine Reibwertverminderung der Werkzeugoberfläche (aufgrund geringerer Rauheit und besserer Wärmeleitfähigkeit) auftritt. Eine verminderte Prozesstemperatur beim Strangpressen verhindert dann wiederum nachteilige Oxidationseffekte des Strangpressmetalls und wirkt sich vorteilhaft auf die Erzeugnisqualität des Strangpressproduktes aus.

Während sich zudem die vorliegende Erfindung insbesondere eignet, die erfindungsgemäße (ein- oder mehrschichtige) Beschichtung als MT-TiCN-Beschichtung (bzw. MT-TiCNO oder MT-TiCBNO in der dotierten Form) zu realisieren, wobei "MT" den beanspruchten Mitteltemperaturbereich zwischen 700°C und 950°C, bevorzugt <900°C, beschreibt und "TiCN" das Vorhandensein der jeweiligen Elemente in der Beschichtung angibt, ist es gleichwohl von der vorliegenden Erfindung umfasst, etwa zu Ti alternative Metalle vorzusehen oder weitere Metalle zusätzlich hinzuzufügen, hinzu kommt die bereits erwähnte Möglichkeit, durch geeignete Dotierungselemente eine weitere Materialbeeinflussung vorzunehmen.

In der Verallgemeinerung im Rahmen der Erfindung würde etwa die Stöchiometrie des erfindungsgemäßen MT-TiCN-Prozesses auf weitere mögliche Metalle zur Beschichtung von Strangpresswerkzeugen wie folgt aussehen:

2 MeClₙ + CH₃CN + (n+0,5) H₂ → 2 MeC₀,₅N₀,₅ + CH₄ + 2n HCl (Me=Metall)

In der im Rahmen der vorliegenden Erfindung bevorzugten Verwendung von Ti als Metall würde, unter Verwendung geeigneter Precursor-Gase, folgende Reaktionsgleichung gelten können:

2TiCl₄ + 4H2 + N2 → 2TiN + 8HCl

Die Ti-basierten Schichten werden überwiegend als Grundschicht verwendet, durch die eine bessere Stützwirkung für eine oder mehrere weiterbildungsgemäß zusätzliche und mit spezifischen Eigenschaften versehene Deckschicht(en) ausübt und deren spezifische stengelige Struktur sich auf die Deckschicht(en) teilweise überträgt.

Insbesondere durch das Vorsehen des zweiten, das Element Kohlenstoff für die Beschichtung bereitstellenden Reaktionsgases und bei der erfindungsgemäßen Mitteltemperatur lässt sich damit das erfindungsgemäß vorteilhafte günstige Verhältnis von C/N>1, und bevorzugt C/N≥1,5, günstig erreichen (gemessen z.B. mittels Sekundärionenmassenspektroskopie SiMs), wobei eine typische Realisierungsform der Erfindung etwa ein C:N Verhältnis von 60:40 erlaubt.

Das zweite Reaktionsgas, als typischer sogenannter Precursor im Rahmen des erfindungsgemäßen CVD-Mitteltemperaturverfahrens, wird typischerweise in Form von Acetonitril (CH₃CN) zugeführt, jedoch sind auch andere Kohlenstoffverbindungen für die Beschichtung bereitstellende Gase denkbar.

Auch ist es im Rahmen bevorzugter Weiterbildungen der Erfindung vorgesehen, die im Rahmen des erfindungsgemäßen Mitteltemperatur-CVD-Beschichtungsprozesses aufgebrachte Beschichtung mit einer (wiederum mindestens einlagigen) Deckschicht zu versehen, welche beispielsweise im Hinblick auf Textur, Rauheit und Wärmeleitfähigkeit optimiert ist. Eine typische Deckschicht könnte etwa Al2O3, TiBN oder TiO aufweisen, wobei es sich im Rahmen bevorzugter Ausführungsbeispiele zum Aufbringen der Deckschicht als durchaus sinnvoll erwiesen hat, die Deckschicht selbst mit CVD-Prozesstemperaturen oberhalb der Mitteltemperatur, also etwa oberhalb von 950°C, aufzubringen, ohne dass die vorteilhaften Eigenschaften der Gesamtanordnung beeinträchtigt werden. Prinzipiell ist auch eine Deckschicht aufweisend ZrN, CrN oder CrC denkbar.

Im Ergebnis entsteht so ein auf einem typischen Warmarbeitsstahl od.dgl. Substratmaterial durch eine erfindungsgemäße Beschichtung aufgebautes Werkzeug, welches zum Realisieren einer Vielzahl von Strangpressprofilen sowie für nahezu beliebige, auch abrasive (und damit besonders verschleißfördernde, da etwa Si-haltige) und klebende (Cu- oder Mn-haltige) Strangpressmetalle geeignet ist. Entsprechend ist es im Rahmen bevorzugter Anwendungen der Erfindung sinnvoll, verschiedene exponierte bzw. verschleißanfällige Abschnitte und Bereiche eines Strangpresswerkzeugs in der erfindungsgemäßen Weise zu beschichten, wobei sich die vorliegende Erfindung insbesondere auch als günstig für besonders verschleißanfällige Rundungs-, Gleit-, Streben- oder Konusabschnitte im Rahmen eines Strangpresswerkzeugs erweist.

Erfindungsgemäß vorteilhaft und im Rahmen der Erfindung liegen damit typische Beschichtungsdicken im Bereich zwischen 5µ - 15µ, welche regelmäßig eine Oberflächenhärte im Bereich zwischen 2000 und 3500 HV ermöglichen, insbesondere Härtebereiche, welche zwischen 2500 und 3000 HV liegen.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
- Fig. 1: eine Längsschnittansicht durch ein Strangpresswerkzeug, welches gemäß der vorliegenden Erfindung mit einer Beschichtung versehen ist bzw. wird;
- Fig. 2: eine Perspektivansicht des Werkzeugs gemäß Fig. 1 mit einends zugeführtem Strangpressprofil (z.B.: Rohre) sowie anderenends (austrittsseitlich) aus dem Werkzeug gebildetem Rohrprofil;
- Fig. 3: eine Schemaansicht einer durch das Verfahren zum Erzeugen einer einschichtigen Beschichtung auf einer Oberfläche des Strangpresswerkzeugs gemäß einer ersten Ausführungsform der vorliegenden Erfindung gebildeten Schicht;
- Fig. 4: eine Detailansicht einer Mehrschichtstruktur einer auf einer Oberfläche des Strangpresswerkzeugs gebildeten mehrschichtigen Beschichtung als zweite Ausführungsform der vorliegenden Erfindung und
- Fig. 5: ein schematisches Blockschaltbild zum Verdeutlichen eines exemplarischen Anlagenkontexts zur Realisierung des erfindungsgemäßen Verfahrens bzw. zum Herstellen des erfindungsgemäß beschichteten Strangpresswerkzeugs.

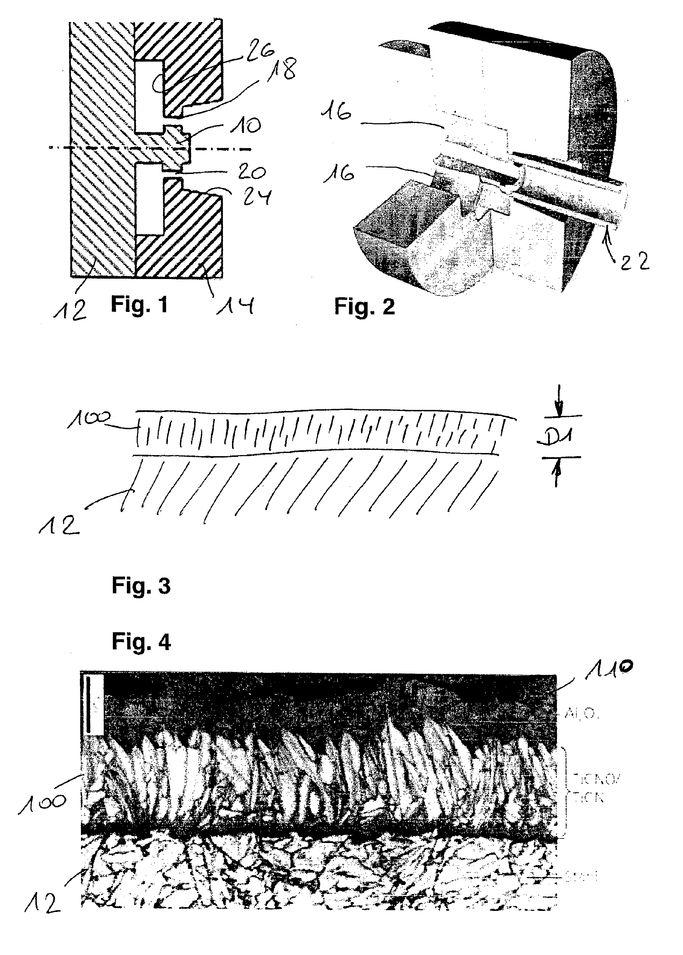

Die Fig. 1 und 2 verdeutlichen ein in ansonsten bekannter Weise realisiertes, zweiteiliges Strangpresswerkzeug. Genauer gesagt weist dieses ein einen Dorn 10 ausbildenden Dornteil 12 sowie eine damit zusammenwirkende Matrizenplatte 14 auf. In ansonsten bekannter Weise bildet der Dornteil eine Mehrzahl von umfangsseitig um den Dorn 10 herum vorgesehener Einläufe 16 aus, welche zur Führung des während des Pressens duktilen Metalls durch einen zwischen dem Dorn 10 und einer umlaufenden Lauffläche 18 der Matrizenplatte 14 gebildeten Presskanal am Dornteil 20 dient. Dessen durch die Zylinderwand 18 begrenzte Abmessungen bestimmen dann einen Außendurchmesser des im gezeigten Beispiel erhaltenen Rohrs 22 von z. B. 30 mm (dessen Innendurchmesser durch einen maximalen Außendurchmesser des Dorns 10 bestimmt wird und dessen Außendurchmesser durch 18 bestimmt wird).

Das in Fig. 1 und Fig. 2 gezeigte Strangpresswerkzeug ist rein exemplarisch und beispielhaft gezeigt; zur weiteren Erläuterung derartiger Strangpresswerkzeuge im Rahmen der vorliegenden Erfindung wird beispielsweise auch auf das Ausführungsbeispiel der EP 1 001 884 B1 verwiesen.

In erfindungsgemäß vorteilhafter Weise ist ein derartiges Werkzeug an seinen Kontaktflächen mit dem Strangpressmaterial mit einer Beschichtung versehen, wie nachfolgend beschrieben werden wird. Dabei ist es bevorzugt, die erfindungsgemäße Beschichtung ganzflächig aufzubringen, d.h. sämtliche Kontaktflächen der Werkzeugteile mit dieser Beschichtung zu versehen, gleichermaßen ist es jedoch auch von der vorliegenden Erfindung umfasst, diese Beschichtung lediglich selektiv oder partiell insbesondere auf besonders exponierten Stellen aufzubringen, wobei dafür insbesondere die den Presskanal 20 begrenzenden Flächen (nämlich die außenzylindrische Fläche 18 der Matrizenplatte sowie die äußere Mantelfläche des Dorns 10) in Betracht kommen, ferner die dem Kanal 20 vorgelagerte Innenfläche 26 der Matrizenplatte sowie die Innenflächen der Einläufe 16. Wie nachfolgend an den Beschichtungsbeispielen erläutert werden wird, ermöglicht gerade die Beschichtung gemäß der vorliegenden Erfindung eine besonders verschleißfeste und damit die Nutzungsdauer des gezeigten Werkzeugs signifikant steigernde Beschichtung.

Im Rahmen der ersten Ausführungsform der vorliegenden Erfindung werden die Körper 12 bzw. 14 des gezeigten Strangpresswerkzeugs aus einem hochwarmfesten, dauerwärmebeständigen (und anlassbeständigen) Stahl bereitgestellt, typischerweise in Form eines ansonsten bekannten Warmarbeitsstahls. Ein derartiger Cr-Mo-V-legierter Stahl ist beispielsweise in Form der standardisierten Stahlsorten 2344, 2367 oder dergleichen bekannt.

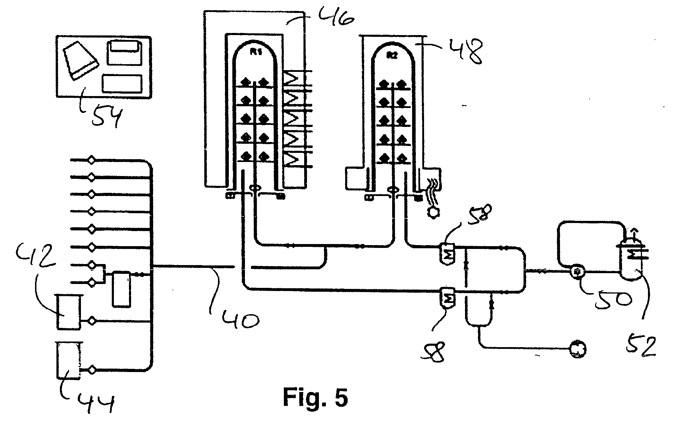

Im Rahmen der vorliegenden Erfindung werden diese Stahlkörper nunmehr im Rahmen eines Mitteltemperatur-CVD-Prozesses mit der in Fig. 3 schematisch gezeigten Beschichtung 100 versehen. Der durchgeführte Prozess ist gemäß der vorliegenden Erfindung ein so genannter Mitteltemperatur-Prozess, d.h. er wird als CVD-Beschichtungsprozess bei einer Temperatur im Bereich < 950°C und oberhalb 700°C durchgeführt, wobei sich der Temperaturbereich für die CVD-Beschichtung im Bereich zwischen 800°C und 900°C als besonders bevorzugt herausgestellt hat. Eine typische Realisierungsform einer geeigneten Beschichtungsanlage zeigt das Blockschaltbild der Fig. 5, in welchem ein Reaktor R1, R2 über eine Anordnung aus Gasleitungen 40 mit Reaktionsgasen beschickt wird; im vorliegenden Ausführungsbeispiel handelt es sich bei dem schematisch gezeigten Gaszufluss 42 um TiCl₄, bei dem Gaszufluss 44 um CH₃CN als Precursorgas. Zusätzlich erfolgt die Zufuhr von Wasserstoff. Der Reaktor wird in ansonsten bekannter Weise mittels eines Ofens 46 auf die zur Abscheidung der Schicht 100 benötigte Temperatur, hier 850°C, geheizt, wobei danach eine Kühlhaube 48 zur Abkühlung des Reaktors bzw. der im Reaktor befindlichen Körper dient und mit Umgebungsluft gekühlt wird. Eine Flüssigringspumpe 50 entfernt Restgase aus der Reaktoranordnung im Zusammenwirken mit einer Neutralisationsanordnung 52. Im schematischen Blockschaltbild der Fig. 5, dessen Aufbau i.Ü. gängigen CVD-Beschichtungsanlagen entspricht, gleichwohl für die Besonderheiten der erfindungsgemäßen Werkzeugbeschichtung parametrisiert ist, zeigt das Bezugszeichen 54 die für die Steuerung der Anlage notwendige Steuereinheit; die als 58 gezeichneten Einheiten stellen Kühlfallen dar.

Im gezeigten Ausführungsbeispiel wird der Mitteltemperatur (MT)-TiCN Beschichtungsprozess unter Verwendung von CH3CN und TiCl4 durchgeführt.

Die Reaktionstemperatur beträgt 850°C, die beteiligten Reaktionsgase werden, erfindungsgemäß angepasst an die Besonderheiten des Trägermaterials aus Warmarbeitsstahl, wie folgt eingestellt und parametrisiert: Bei einem Reaktordruck von 50mbar - 200mbar erfolgt der Zufluss von H2 mit etwa 20l/min, von TiCl mit ca. 3,8 ml/min und von CH3CN mit ca. 0,5 ml/min.

Die schematische Darstellung der Fig. 3 verdeutlicht das Ergebnis dieses Ausführungsbeispiels. Es entsteht eine kolumnare (stengelige) Schicht 100 einer Dicke von 5 - 10µm auf dem Trägersubstrat der Werkzeugteile 12 bzw. 14. Die in der Fig. 3 angedeutete stengelige Struktur zeigt dabei, analog der Fotografie der Fig. 4, klar voneinander abgegrenzte, voneinander über Zwischenräume beabstandete Stengel (Kolumnen), welche sich senkrecht zu einer äußeren Oberfläche der Beschichtung bzw. einer Substratoberfläche erstrecken, in erfindungsgemäß besonders vorteilhafter Weise günstig an der Substratoberfläche haften und die für die für günstige Verschleißeigenschaften vorteilhafte Zähigkeit des Stahlwerkzeugs erhöhen. Gleichzeitig zeigt die so beschichtete Oberfläche Härteeigenschaften im Bereich zwischen ca. 2500 HV und 3000 HV.

Wie sich unmittelbar aus der obigen Stöchiometrie des hier exemplarisch beschriebenen Prozesses ergibt, weist in der Beschichtung ein C/N-Verhältnis entsprechend ca. 1,5 : 1 (60:40) auf (gemessen in Atomprozent).

Ein derartig beschichtetes Werkzeug, welches nach der Entnahme aus dem CVD-Reaktor noch auf Umgebungstemperatur abgekühlt und danach wärmebehandelt wird, eignet sich dann zum Strangpressen typischer Profile mit gängigen Strangpressmaterialen. Im exemplarischen Ausführungsbeispiel der Fig. 2 weist das Rohr 22 einen Außendurchmesser von 30mm auf, wobei Strangpresswerkstoff DIN EN 6060 (AlMnSi0,5) mit einer Produktionsgeschwindigkeit des Profils 22 von ca. 20m/min - 30m/min (bezogen auf die Austrittsgeschwindigkeit des Profils am Werkzeugaustritt) gepresst wird.

Vorteilhaft zeigt sich eine gegenüber konventionell beschichteten oder unbeschichteten Strangpresswerkzeugen erhöhte Oberflächengüte des hergestellten Profils, insbesondere eine glattere, feinere Oberfläche (signifikant reduzierte Rauheit Rₘₐₓ). Im Rahmen des durchgeführten Ausführungsbeispiels ist gegenüber einem konventionell (etwa analog der EP 1 011 884 B1) beschichteten Strangpresswerkzeugs bei ansonsten gleichbleibenden Randbedingungen vorteilhaft eine um ca. 10°C bis 30°C verminderte Produkttemperatur am Profilaustritt festzustellen. Grund hierfür ist, neben vorteilhaft niedrigeren Reibwerten des erfindungsgemäß beschichteten Werkzeugs, eine verbesserte Wärmeabfuhr durch die stengelige Beschichtung 100 in den Werkzeugkörpern 12 bzw. 14. Vorteilhaftes Ergebnis dieser niedrigeren Temperatur ist dann wiederum eine geringere Materialversprödung des Werkzeugs, welches sich positiv auf die Verschleißfestigkeit aufweist. Zudem konnte durch mikroskopische Beobachtungen festgestellt werden, dass die erfindungsgemäß hergestellte Beschichtung weniger Produktoberflächendefekte wie störende Mikrokörper ("Pickups") zulässt bzw. eine bessere Profiloberflächenrauheit erzeugt..

Eine Variante der vorliegenden Erfindung als zweites Ausführungsbeispiel folgt im Wesentlichen der vorgenannten Stöchiometrie. Zusätzlich wird allerdings während des Mitteltemperatur-CVD-Beschichtungsverfahrens eine Dotierung z.B. mit Bor durchgeführt; Bor wird in Form eines Reaktionsgases, (BCI3) in den CVD-Reaktorprozess eingebracht.

Eine derartige Dotierung führt zunächst zu einer feineren Struktur der Beschichtung 100, bewirkt eine höhere Schichthärte und senkt signifikant die so genannte Klebeneigung der Beschichtung gegenüber dem Strangpressmetall ab. Dabei diffundiert z.B. Bor in die TiCN-Schicht, wobei eine verringerte Korngröße der Beschichtung erreicht wird; gleichzeitig verbleibt die vorteilhafte kolumnare Struktur.

Eine weitere Ausführungsform der Erfindung verdeutlicht die Schnittansicht der Fig. 4. Die im linken oberen Bereich gezeigte Maßstabsangabe entspricht 5µm.

Bei diesem Ausführungsbeispiel wurde, analog dem ersten Ausführungsbeispiel, ein Warmarbeitstahl als Substratmaterial für die Werkzeugkörper 12 bzw. 14 gewählt, und mittels der vorbeschriebenen Stöchiometrie wurde eine TiCN-Beschichtung 100 abgeschieden. Zusätzlich erfolgte eine Dotierung dieser Beschichtung durch Zr, wobei dieses Element in Form von Zirkonchloriden in den CVD-Reaktor eingebracht wurde. Auch hier erfolgte die Herstellung der Schicht 100 bei Mitteltemperatur, d.h. bei einer Reaktions- und Abscheidetemperatur von 800°C - 900°C wobei, entsprechend dem gezeigten Maßstab, diese Mitteltemperatur-Schicht 100 mit einer wirksamen Schichtdicke der stengeligen Struktur im Bereich zwischen ca. 5µm - 10µm abgeschieden wurde.

Im Gegensatz zum Ausführungsbeispiel der Fig. 3 erfolgte jedoch nach dem Mitteltemperatur-Prozess ein nachfolgendes Aufbringen einer zweiten Schicht 110, hier mittels Al₂O₃, durch folgende Reaktion:
1. Al + 3HCl <-> AlCl3 + 3/2 H2
2. CO2 + H2 <-> H2O +CO
3. 2AlCl3 + 3H2O <-> Al2O3 + 6HCl

Diese Deckschicht (auch als Funktionsschicht bezeichnet) wird im Gegensatz zur Schicht 100 bei einer so genannten Hochtemperatur, im Ausführungsbeispiel bei 1000°C, abgeschieden und liegt nach Beendigung des Prozesses mit einer Schichtdicke von 2µm - 5µm vor. Im Gegensatz zu der zähen Mitteltemperaturschicht 100 ist die Funktionsschicht 110 besonders hart, wirkt damit synergistisch mit der Schicht 100 zusammen und senkt eine durch den Strangpressvorgang wirkende Abrasion weiter ab.

Erfindungsgemäß vorteilhaft ändert sich jedoch durch das nachfolgende Aufbringen der Schicht 110 das C/N-Verhältnis der Mitteltemperatur-Schicht 110 nicht, so dass die in der Fig. 4 in der Schnittansicht gezeigte Gesamtanordnung, bedingt durch die erfindungsgemäß vorteilhafte Schicht 100, ihre günstigen Zähigkeitseigenschaften behält, wobei insbesondere auch die kolumnare bzw. stengelige Struktur eine günstige Haftung der oberen Funktionsschicht 110 bewirkt.

Auch das so geschaffene Werkzeug besitzt eine Rockwell-Härte < 60 (typischer Weise zwischen 44 - 55, bevorzugt im Bereich zwischen 48 - 54).

Die vorliegende Erfindung ist weder auf die gezeigte Werkzeuggeometrie (bzw. die dort beschichteten Flächen) beschränkt, noch auf die exemplarisch eingesetzten Substrat-, Strangpress- und Beschichtungswerkstoffe (eingeschlossen verwendete Gase). Vielmehr eignen sich zur Realisierung der vorliegenden Erfindung jegliche Mitteltemperatur-CVD-taugliche Materialien für die Schicht 100, wobei Ti als Metallelement zwar bevorzugt ist, jedoch nicht notwendiger Weise vorhanden sein muss. Auch ist es im Rahmen der vorliegenden Erfindung möglich, die so erzeugte Schicht zu dotieren, wobei in dem erwähnten Element B insbesondere auch Zr, Cr oder dergleichen in Betracht kommen. Auch ist die Deckschicht (Funktionsschicht) als Al₂O₃ lediglich exemplarisch, gleichermaßen denkbar ist etwa eine TiO Deckschicht oder eine andere, bevorzugt harte und weiter bevorzugt und in Abkehr von der MT-Schicht bei Hochtemperatur aufgebrachte Schicht.

Im Hinblick auf die Werkzeuggeometrie eignet sich die vorliegende Erfindung insbesondere, während der Strangpressens besonders beanspruchte Ecken und Kanten zu beschichten, wobei es weiterbildungsgemäß und in der Realisierung der Erfindung als erfindungsgemäß beschichtetes Strangpresswerkzeug günstig ist, Kanten im Bereich des Kanal-Einlaufs (und/oder Auslaufs) mit Kantengeometrie im Bereich zwischen ca. 0,1 und ca. 2mm auszugestalten, welche dann die erfindungsgemäße Beschichtung tragen.

Auch ist es prinzipiell denkbar und von der Erfindung umfasst, als Strangpressmaterial, über ansonsten bekannte und übliche Aluminium-basierte Legierungen hinaus, andere Leichtmetalle oder damit zusammengesetzte Legierungen einzusetzen, wie etwa Magnesium- oder Zinklegierungen, alternativ Schwermetalllegierungen, etwa auf Kupfer und/oder Messingbasis (mit dann entsprechend höheren Verarbeitungstemperaturen). Unabhängig von den genannten metallischen Strangpressverfahren dürfte sich zudem die vorliegende Erfindung gut eignen, um in verschließgünstiger Weise Kunststoffe, etwa CFK-Kunststoffe oder dergleichen, zu verarbeiten. Zusätzlich ist zu erwarten, dass besonders harte bzw. abrasive Strangpressmaterialien (etwa pulvermetallurgisches Aluminium mit hohem SI-Anteil, denkbar bis zu 14%) verarbeitet wird, ebenso wie auch Aluminium mit zugesetzten Additiven zur Veränderung der Materialkennwerte (wie Nanopartikel, SiC oder dergleichen).

Im Ergebnis ermöglicht es die vorliegende Erfindung in überraschend eleganter und wirksamer Weise, in Abkehr von der bekannten Hochtemperatur-Beschichtungstechnologie eine Mitteltemperaturschicht auf einem (Warmarbeits-) Stahlsubstrat als Strangpresswerkzeug vorzusehen, wobei dann entweder diese Beschichtung einschichtig, alternativ als Mehrschicht mit einer darauf aufgebrachten, beispielsweise als Hochtemperatur- Funktionsschicht ausgebildeten Schicht eine wirkungsvolle Kombination erfährt.

## Patentansprüche

1. Verfahren zum Erzeugen einer ein- oder mehrschichtigen Beschichtung auf einem Strangpresswerkzeug als Substratkörper aus einem hochwarmfesten und/oder dauerwarmbeständigen Stahlmaterial mittels chemischer Gasphasenabscheidung (CVD), mit den Schritten:
- Bereitstellen des Substratkörpers aus dem bei einer Strangpress-Betriebstemperatur im Bereich zwischen 400°C und 950°C dauerwarmfesten und zum Zusammenwirken mit duktilem Strangpressmetall vorgesehenem Stahlmaterial,
- Einleiten eines ein Metall aufweisenden ersten Reaktionsgases in einen den Substratkörper aufnehmenden Reaktor zum Bereitstellen eines Beschichtungsmetalls,
- Einleiten eines zweiten, eine Kohlenstoffverbindung aufweisenden Reaktionsgases in den Reaktor zum Bereitstellen von Kohlenstoff für die Beschichtung,
- wobei das erste und/oder das zweite Reaktionsgas oder ein weiteres Reaktionsgas Stickstoff für die Beschichtung bereitstellen,
- Durchführen eines CVD-Beschichtungsprozesses mit den Reaktionsgasen bei einer Mitteltemperatur im Bereich von 700°C bis 950°C zum Erzeugen der Beschichtung so,
dass das Verhältnis zwischen Kohlenstoff und Stickstoff in der mindestens einen Schicht der Beschichtung C/N>1 beträgt und/oder die mindestens eine Schicht der Beschichtung eine kolumnare und/oder stengelige Struktur mit einer Vielzahl von einander benachbarten, zueinander parallel und senkrecht zur Substratoberfläche ausgerichteten Gefügeabschnitten aufweist.

2. Verfahren nach Anspruch 1,
**dadurch gekennzeichnet,**
**dass** das erste Reaktionsgas für das Beschichtungsmetall der Metallverbindung so eingerichtet wird, dass das Metall aus der Gruppe bestehend aus: Ti, Zr, B, Cr, Cu, Mg, Hf ausgewählt wird.

3. Verfahren nach einem der Ansprüche 1 oder 2,
**dadurch gekennzeichnet,**
**dass** das erste Reaktionsgas TiCl₄ aufweist.

4. Verfahren nach einem der vorhergehenden Ansprüche,
**dadurch gekennzeichnet,**
**dass** das zweite Reaktionsgas ausgewählt wird aus der Gruppe bestehend aus CH₃CN, C₂H₆ oder Mischungen von diesen.

5. Verfahren nach einem der vorhergehenden Ansprüche,
**dadurch gekennzeichnet,**
**dass** der dauerwarmfeste Stahl nach der Beschichtung eine durch ein Verfahren zur Ermittlung der Schlagarbeit gemäß DIN SEP 1314 ermittelte Zähigkeit in einem Bereich zwischen 200 J und 400 J bei einer Festigkeit in einem Bereich zwischen 44 HRC und 55 HRC aufweist.

6. Verfahren nach einem der vorhergehenden Ansprüche,
**dadurch gekennzeichnet,**
**dass** die mindestens eine Schicht der Beschichtung und/oder die Beschichtung mit einer Schichtdicke 5µm - 15µm abgeschieden wird.

7. Verfahren nach einem der vorhergehenden Ansprüche,
**dadurch gekennzeichnet,**
**dass** auf der Beschichtung eine Deckschicht aufgebracht wird, die oberhalb einer CVD-Mitteltemperatur von 950°C aufgebracht wird.

8. Verfahren nach Anspruch 7,
**dadurch gekennzeichnet,**
**dass** ein Material der Deckschicht ausgewählt wird aus der Gruppe bestehend aus: TiO, Al203, TiBN.

9. Verfahren nach einem der vorhergehenden Ansprüche,
**dadurch gekennzeichnet,**
**dass** die Deckschicht oder eine äußerste Schicht der Beschichtung eine Oberflächenrauhigkeit in einem Bereich zwischen Rz 0µ - 4 und/oder Rz < 1,5µ, aufweist und/oder eine Härte, gemessen nach Vickers, im Bereich zwischen 2000 und 3500 HV aufweist.

10. Verfahren nach einem der vorhergehenden Ansprüche,
**dadurch gekennzeichnet,**
**dass** der beschichtete Substratkörper, nach dem Ende des CVD-Beschichtungsprozesses, zur Wärmebehandlung mit einer Anlass- oder Warmauslagertemperatur wärmebehandelt wird.

11. Verfahren nach einem der Ansprüche 1 bis 10,
**dadurch gekennzeichnet,**
**dass** das Strangpresswerkzeug als zweiteiliges Werkzeug (10, 12) aufweisend ein Dornteil sowie eine Matrizenplatte ausgebildet ist und auf dem Dornteil sowie auf der Matrizenplatte jeweils zumindest abschnittsweise die Beschichtung erzeugt wird.

12. Verfahren nach Anspruch 11,
**dadurch gekennzeichnet,**
**dass** die Beschichtung auf einen Führungs- und/oder Flusskanal für das duktile Strangpressmaterial ausbildenden Begrenzungswänden des Werkzeugs aufgebracht ist, wobei eine Einlass- und/oder Auslasskante des Kanals einen mit der Beschichtung versehenen Radius aufweist.

## Claims

1. A method for producing a single-layer or multilayer coating on an extrusion die as a substrate body of a heat-resistant and/or long-term heat-resistant steel material by means of chemical vapour deposition (CVD), comprising the steps of:
- providing the substrate body of the steel material that has long-term heat resistance at an extrusion operating temperature in the range between 400°C and 950°C and is intended for interacting with ductile extrusion metal,
- introducing a first reaction gas containing a metal into a reactor receiving the substrate body in order to provide a coating metal,
- introducing a second reaction gas containing a carbon compound into the reactor in order to provide carbon for the coating,
- wherein the first and/or the second reaction gas or a further reaction gas provide(s) nitrogen for the coating,
- carrying out a CVD coating process with the reaction gases at an average temperature in the range from 700°C to 950°C in order to produce the coating such
that the ratio between the carbon and nitrogen in the at least one layer of the coating is C/N>1 and/or
the at least one layer of the coating has a columnar and/or stalky structure with a plurality of structural sections that lie adjacent to one another and are aligned parallel to one another and perpendicular to the substrate surface.

2. The method according to Claim 1,
**characterized in**
**that** the first reaction gas for the coating metal of the metal compound is realized in such a way that the metal is selected from the group consisting of: Ti, Zr, B, Cr, Cu, Mg, Hf.

3. The method according to one of Claims 1 or 2,
**characterized in**
**that** the first reaction gas contains TiCl₄.

4. The method according to one of the preceding claims,
**characterized in**
**that** the second reaction gas is selected from the group consisting of CH₃CN, C₂H₆ or mixtures thereof.

5. The method according to one of the preceding claims,
**characterized in**
**that** the steel with long-term heat resistance has after the coating process a toughness determined with a method for determining the impact work according to DIN SEP 1314 in the range between 200 J and 400 J at a strength in the range between 44 HRC and 55 HRC.

6. The method according to one of the preceding claims,
**characterized in**
**that** the at least one layer of the coating and/or the coating is deposited with a layer thickness of 5µm - 15µm.

7. The method according to one of the preceding claims,
**characterized in**
**that** a cover layer is applied onto the coating above an average CVD temperature of 950°C.

8. The method according to Claim 7,
**characterized in**
**that** the material of the cover layer is selected from the group consisting of: TiO, A1203, TiBN.

9. The method according to one of the preceding claims,
**characterized in**
**that** the cover layer or an outer layer of the coating has a surface roughness in the range between Rz 0µ - 4 and/or Rz < 1.5µ and/or a hardness measured according to Vickers in the range between 2000 and 3500 HV.

10. The method according to one of the preceding claims,
**characterized in**
**that** the coated substrate body is after the end of the CVD coating process heat-treated with a tempering temperature or artificial aging temperature.

11. The method according to one of Claims 1 to 10,
**characterized in**
**that** the extrusion die is realized in the form of a two-part die (10, 12) with a mandrel part and a die bolster and the coating is respectively produced at least sectionally on the mandrel part and on the die bolster.

12. The method according to Claim 11,
**characterized in**
**that** the coating is applied on the walls of the die that define a guide channel and/or flow channel for the ductile extrusion material, wherein an inlet and/or outlet edge of the channel has a radius provided with the coating.

## Revendications

1. Procédé pour produire un revêtement à une ou plusieurs couches sur un outil d'extrusion comme corps de substrat en un matériau d'acier résistant à une température élevée et/ou résistant au fluage par un dépôt chimique en phase vapeur (CVD), présentant les étapes :
- mise à disposition du corps de substrat en un matériau d'acier résistant au fluage à une température de fonctionnement d'une extrudeuse dans la plage entre 400°C et 950°C et prévu pour interagir avec le métal ductile de l'extrudeuse,
- introduction d'un premier gaz de réaction, présentant un métal, dans un réacteur recevant le corps de substrat pour la mise à disposition d'un métal de revêtement,
- introduction d'un deuxième gaz de réaction, présentant un composé carboné, dans le réacteur pour la mise à disposition de carbone pour le revêtement,
- le premier et/ou le deuxième gaz de réaction ou un autre gaz de réaction mettant à disposition de l'azote pour le revêtement,
- réalisation d'un procédé de revêtement par CVD avec les gaz de réaction à une température moyenne dans la plage de 700°C à 950°C pour produire le revêtement, de manière telle
que le rapport entre le carbone et l'azote dans ladite au moins une couche du revêtement C/N>1 et/ou ladite au moins une couche du revêtement présente une structure en colonne et/ou en tige présentant une pluralité de sections de structure adjacentes les unes aux autres, orientées parallèlement les unes aux autres et perpendiculairement à la surface du substrat.

2. Procédé selon la revendication 1, **caractérisé en ce que** le premier gaz de réaction pour le métal de revêtement du composé métallique est conçu de manière telle que le métal est choisi dans le groupe constitué par : Ti, Zr, B, Cr, Cu, Mg, Hf.

3. Procédé selon l'une quelconque des revendications 1 ou 2, **caractérisé en ce que** le premier gaz de réaction présente du TiCl₄.

4. Procédé selon l'une quelconque des revendications précédentes, **caractérisé en ce que** le deuxième gaz de réaction est choisi dans le groupe constitué par CH₃CN, C₂H₆ ou leurs mélanges.

5. Procédé selon l'une quelconque des revendications précédentes, **caractérisé en ce que** l'acier résistant au fluage présente, après le revêtement, une ténacité déterminée par un procédé pour déterminer l'énergie absorbée selon la norme DIN SEP 1314, dans une plage entre 200 J et 400 J à une résistance dans la plage entre 44 HRC et 55 HRC.

6. Procédé selon l'une quelconque des revendications précédentes, **caractérisé en ce que** ladite au moins une couche du revêtement et/ou le revêtement est déposé(e) à une épaisseur de couche de 5 µm-15 µm.

7. Procédé selon l'une quelconque des revendications précédentes, **caractérisé en ce qu'**on applique, sur le revêtement, une couche de recouvrement qui est appliquée au-dessus d'une température moyenne de CVD de 950°C.

8. Procédé selon la revendication 7, **caractérisé en ce qu'**un matériau de la couche de recouvrement est choisi dans le groupe constitué par : TiO, Al₂O₃, TiBN.

9. Procédé selon l'une quelconque des revendications précédentes, **caractérisé en ce que** la couche de recouvrement ou une couche externe du revêtement présente une rugosité de surface dans une plage entre Rz 0 µ - 4 µ et/ou Rz < 1,5 µ, et/ou une dureté, mesurée selon Vickers, dans la plage entre 2000 et 3500 HV.

10. Procédé selon l'une quelconque des revendications précédentes, **caractérisé en ce que** le corps de substrat revêtu, après la fin du procédé de revêtement par CVD, est traité thermiquement à une température de recuit ou de vieillissement à chaud en vue du traitement thermique.

11. Procédé selon l'une quelconque des revendications 1 à 10, **caractérisé en ce que** l'outil d'extrudeuse est conçu comme un outil en deux parties (10, 12) présentant une partie de mandrin ainsi qu'une plaque de matrice et le revêtement est produit sur la partie de mandrin ainsi que sur la plaque de matrice, à chaque fois au moins par sections.

12. Procédé selon la revendication 11, **caractérisé en ce que** le revêtement est appliqué sur les parois limites formant un canal de guidage et/ou d'écoulement pour le matériau d'extrusion ductile, un bord d'entrée et/ou de sortie du canal présentant un rayon pourvu du revêtement.
